(19) **Europäisches Patentamt European Patent Office Office européen des brevets**

(11) **EP 4 693 108 A1**

(12) **EUROPEAN PATENT APPLICATION**

(43) Date of publication:
**11.02.2026 Bulletin 2026/07**

(21) Application number: **25194897.2**

(22) Date of filing: **08.08.2025**

(51) International Patent Classification (IPC):
**G06N 3/065** (2023.01)

(52) Cooperative Patent Classification (CPC):
**G06N 3/065**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **09.08.2024 KR 20240106829**

(71) Applicant: **Korea University Research and Business Foundation**
**Seoul 02841 (KR)**

(72) Inventors:
• **KIM, Sang Sig**
  **06630 Seoul (KR)**
• **CHO, Kyoung Ah**
  **04989 Seoul (KR)**
• **SHIN, Yun Woo**
  **14207 Gyeonggi-do (KR)**
• **HEO, Hyo Joo**
  **02857 Seoul (KR)**

(74) Representative: **Prüfer & Partner mbB**
**Patentanwälte · Rechtsanwälte**
**Sohnckestraße 12**
**81479 München (DE)**

(54) **OSCILLATORY NEURAL NETWORK CIRCUITRY USING OSCILLATORS COMPRISING GATED DIODE**

(57)     Disclosed is an oscillatory neural network circuitry using oscillators including a gated diode. An oscillatory neural network circuitry according to an embodiment of the present disclosure using oscillators including a gated diode can represent at least two graph colors of an input graph based on phase differences in output voltages over time, as phase differences occur in the output voltages depending on time differences of input voltages applied to at least two gated diodes constituting at least two oscillators.

【FIG. 7A】

**Description**

CROSS-REFERENCE TO RELATED APPLICATION

This application claims priority to Korean Patent Application No. 10-2024-0106829, filed on August 09, 2024 in the Korean Intellectual Property Office, the disclosure of which is incorporated herein by reference.

## BACKGROUND OF THE DISCLOSURE

### Field of the Disclosure

The present disclosure relates to an oscillatory neural network circuitry using oscillators including a gated diode, and more particularly, to a technique for implementing an oscillatory neural network circuitry in which oscillators are realized by utilizing a gated diode and a resistor that repeatedly generate and extinguish a positive feedback loop, and which solves combinatorial optimization problems in conjunction with an image processor based on coupling and synchronization characteristics among oscillators.

### Description of the Related Art

Existing von Neumann computers, in which processors and memories are physically separated, have recently suffered from bottlenecks in transmitting data signals when processing large volumes of data.
Various technologies have been researched to overcome this problem; however, performance degradation and other issues remain unresolved due to structural limitations.
Meanwhile, research on new computing architectures, such as artificial neural networks that mimic the human brain, has been accelerating.
Among these, oscillatory neural networks (ONNs) are technologies that directly mimic recognition mechanisms based on neuronal oscillations (brain waves) and their interactions, through oscillators and coupling.
Oscillatory neural networks may be applied in various fields, and are particularly noteworthy because they may implement combinatorial optimization problem (COP) solvers and Ising machines in a simple manner.
Oscillators implemented with CMOS circuits, such as ring oscillators or inductor-capacitor (LC) oscillators, according to existing technologies, have high reliability but low area and energy efficiency, making it difficult to realize large-scale neural networks.
In contrast, existing oscillator technologies employing simple structures with high integration, such as metal-insulator transition (MIT) devices, resistive switching devices, or two-dimensional (2D) materials, cannot be applied to existing CMOS processes, and suffer from poor device uniformity and stability, as well as inherent instability due to their operating principles.
Accordingly, there is a need for the development of highly integrated oscillators configured with gated diodes (which may be referred to as silicon nanosheet gated diodes) that operate based on a positive feedback loop with high reliability and are applicable to CMOS processes, as well as oscillatory neural network technology using the same.

## SUMMARY OF THE DISCLOSURE

Therefore, the present disclosure has been made in view of the above problems, and it is an object of the present disclosure to provide an oscillatory neural network circuitry in which oscillators are realized by utilizing a gated diode and a resistor that repeatedly generate and extinguish a positive feedback loop, and which solves combinatorial optimization problems in conjunction with an image processor based on coupling and synchronization characteristics among oscillators.
It is another object of the present disclosure to provide an oscillatory neural network circuitry that overcomes processing speed limitations and performance degradation caused by the separation of memory and processor, by implementing oscillators configured with a gated diode.
It is still another object of the present disclosure to provide an oscillatory neural network circuitry in which a plurality of oscillators coupled by capacitors or resistors may detect edges or solve a graph coloring problem by representing at least two graph colors of an input graph.
It is yet another object of the present disclosure to provide an oscillatory neural network circuitry that may be implemented as image processors and combinatorial optimization problem (COP) solvers, by employing highly reliable and highly integrated oscillators applicable to existing CMOS processes.
In accordance with an aspect of the present disclosure, the above and other objects can be accomplished by the provision of an oscillatory neural network circuitry using oscillators including a gated diode, wherein a $p^+$-i-$n^+$ diode structure is positioned between a drain terminal and a source terminal, a gate insulator is located on an intrinsic region of the $p^+$-i-$n^+$ diode structure, and two gate terminals are located on the gate insulator, thereby forming a gated diode, and wherein the oscillators include a resistor connected in series to the gated diode,

the oscillators output an oscillating output voltage with a constant period as the intrinsic region is changed into either an n* channel region or a p* channel region based on different voltages applied to the two gate terminals of the gated diode, thereby forming a potential barrier in the intrinsic region through electrostatic doping, and as a positive feedback loop associated with the formed potential barrier is repeatedly generated and extinguished according to electron injection variations based on multiple-carrier injection, when at least two oscillators are configured, output terminals corresponding to portions where resistors are connected to the respective gated diodes are coupled with each other through either a capacitor or a resistor, so that a phase difference in output voltage occurs depending on a time difference of input voltages applied to the at least two gated diodes, thereby representing at least two graph colors of an input graph based on the time-dependent phase difference.

When the gated diode includes a $p^+$ drain region between the first gate terminal among the two gate terminals and the drain terminal, and a positive voltage is applied to the first gate terminal, a region under the first gate terminal in the intrinsic region may be included as an n* channel region, and when the gated diode includes an $n^+$ source region between the second gate terminal among the two gate terminals and the source terminal, and a negative voltage is applied to the second gate terminal, a region under the second gate terminal in the intrinsic region may be included as a p* channel region..

When the resistor is connected to the drain terminal, a height of a potential barrier of holes injected from the $p^+$ drain region may be controlled according to a first gate voltage applied to the first gate terminal, and as a latch-up voltage at which a positive feedback loop occurs shifts in a positive direction in proportion to the first gate voltage, amplitudes and frequencies of the oscillators may be changed.

When the resistor is connected to the source terminal, the height of a potential barrier of electrons injected from the $n^+$ source region may be controlled according to a second gate voltage applied to the second gate terminal, and as a latch-up voltage shifts in a negative direction in proportion to the second gate voltage, the amplitudes and frequencies of the oscillators may be changed.

Based on a time difference between a first input voltage and a second input voltage applied to each of the at least two gated diodes, an effect occurs between the at least two gated diodes through the capacitor as time elapses, and a first output pixel value may be determined based on an output voltage that is output in an out-of-phase state representing opposite movement, or, when no time difference occurs such that the first input voltage and the second input voltage are applied at same time, a second output pixel value opposite to the first output pixel value may be determined based on the output voltage that is output in an in-phase state.

When each of the at least two gated diodes is coupled horizontally through the capacitor, the output voltage representing vertical edge components may be output, and when coupled vertically through the capacitor, the output voltage representing horizontal edge components may be output.

When four oscillators are configured, output terminals of a first oscillator, a second oscillator, a third oscillator, and a fourth oscillator constituting the four oscillators may be coupled horizontally or vertically through the capacitor, and may be coupled diagonally through a resistor, such that the outputs coupled through the resistor have same phase, and a phase difference occurs relative to the phase coupled through the capacitor.

The first oscillator may be coupled horizontally with the second oscillator through the capacitor and vertically with the third oscillator, and may output an output voltage having a phase difference from those of the second oscillator and the third oscillator, and may be diagonally coupled with the fourth oscillator through the resistor to output an output voltage of same phase, and the second oscillator may be coupled horizontally with the first oscillator through the capacitor and vertically with the fourth oscillator, and may output an output voltage having a phase difference from those of the first oscillator and the fourth oscillator, and may be diagonally coupled with the third oscillator through the resistor to output an output voltage of same phase.

At least two graph colors consisting of a first color corresponding to an output voltage of the same phase and a second color corresponding to an output voltage with the phase difference may be represented.

By considering the number of nodes, node connections, and node colors constituting the input graph, and by using oscillators corresponding to the number of nodes, a color separation criterion for the phase difference may be determined through phase variations of the oscillators over time, and the at least two graph colors may be represented with colors separated according to the color separation criterion.

**BRIEF DESCRIPTION OF THE DRAWINGS**

The above and other objects, features and other advantages of the present disclosure will be more clearly understood from the following detailed description taken in conjunction with the accompanying drawings, in which:

FIGS. 1A to 1C illustrate diagrams explaining a structure and switching characteristics of a gated diode constituting an oscillatory neural network circuitry according to an embodiment of the present disclosure;

FIGS. 2A to 2C illustrate diagrams explaining the structure and operating characteristics of an oscillator constituting the oscillatory neural network circuitry according to an embodiment of the present disclosure;

FIG. 3 illustrates a diagram explaining the characteristic variations of the oscillator constituting the oscillatory neural network circuitry according to an embodiment of the present disclosure;

FIGS. 4A to 4B illustrate diagrams explaining the tuning characteristics of the oscillator constituting the oscillatory neural network circuitry according to an embodiment of the present disclosure;

FIG. 5 illustrates a diagram explaining the characteristic variations of the oscillator constituting the oscillatory neural network circuitry according to an embodiment of the present disclosure when the oscillator uses electrons as multiple carriers;

FIGS. 6A and 6B illustrate diagrams explaining the tuning characteristics of the oscillator constituting the oscillatory neural network circuitry according to an embodiment of the present disclosure when the oscillator uses electrons as multiple carriers;

FIGS. 7A to 7C illustrate diagrams explaining the oscillatory neural network circuitry according to an embodiment of the present disclosure and edge detection simulation using the same;

FIGS. 8A and 8B illustrate diagrams explaining the circuit diagram and oscillation characteristics of the oscillatory neural network circuitry according to an embodiment of the present disclosure; and

FIGS. 9A to 10 illustrate diagrams explaining configurations for implementing the graph coloring of an input graph by an oscillatory neural network circuitry according to an embodiment of the present disclosure.

## DETAILED DESCRIPTION OF THE DISCLOSURE

The embodiments will be described in detail herein with reference to the drawings.

The embodiments and the terms used herein are not intended to limit the disclosed technology to specific implementations described in this document, but should be understood to include various modifications, equivalents, and/or alternatives thereof.

In the following description of the present disclosure, a detailed description of known functions and configurations incorporated herein will be omitted when it may make the subject matter of the present disclosure unclear.

The terms used in the specification are defined in consideration of functions used in the present disclosure, and can be changed according to the intent or conventionally used methods of clients, operators, and users. Accordingly, definitions of the terms should be understood on the basis of the entire description of the present specification.

In the description of the drawings, like reference numerals may be used for similar elements.

The singular expressions in the present specification may encompass plural expressions unless clearly specified otherwise in context.

In this specification, expressions such as "A or B" and "at least one of A and/or B" may include all possible combinations of the items listed together.

Expressions such as "first" and "second" may be used to qualify the elements irrespective of order or importance, and are used to distinguish one element from another and do not limit the elements.

It will be understood that when an element (e.g., first) is referred to as being "connected to" or "coupled to" another element (e.g., second), it may be directly connected or coupled to the other element or an intervening element (e.g., third) may be present.

As used herein, "configured to" may be used interchangeably with, for example, "suitable for", "ability to", "changed to", "made to", "capable of", or "designed to" in terms of hardware or software.

In some situations, the expression "device configured to" may mean that the device "may For example, in the sentence "processor configured to perform A, B, and C", the processor may refer to a general purpose processor (e.g., CPU or application processor) capable of performing corresponding operation by running a dedicated processor (e.g., embedded processor) for performing the corresponding operation, or one or more software programs stored in a memory device.

In addition, the expression "or" means "inclusive or" rather than "exclusive or".

That is, unless otherwise mentioned or clearly inferred from context, the expression "x uses a or b" means any one of natural inclusive permutations.

Terms, such as "unit" or "module", etc., should be understood as a unit that processes at least one function or operation and that may be embodied in a hardware manner, a software manner, or a combination of the hardware manner and the software manner.

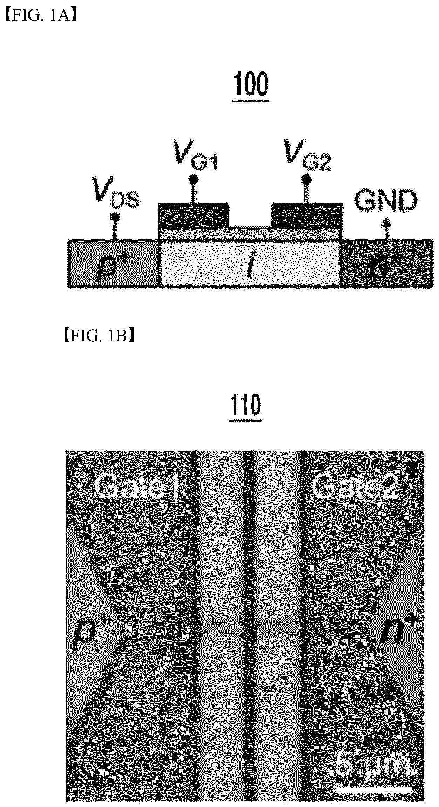

FIGS. 1A to 1C illustrate diagrams explaining a structure and switching characteristics of a gated diode constituting an oscillatory neural network circuitry according to an embodiment of the present disclosure.

FIG. 1A illustrates the structure of a gated diode constituting an oscillatory neural network circuitry according to an embodiment of the present disclosure.

Referring to FIG. 1A, a gated diode 100 constituting the oscillatory neural network circuitry according to an embodiment of the present disclosure has a p+-i-n+ doping structure, with two gate electrodes located on an intrinsic channel region.

The gated diode 100 according to an embodiment of the present disclosure generates and extinguishes a positive feedback loop as the energy band structure of the channel region changes to p+-n*-p*-n+ by electrostatic doping of two gate voltages $V_{G1}$ and $V_{G2}$, and thus exhibits latch-up and latch-down characteristics.

More specifically, the gated diode 100 according to an embodiment of the present disclosure has a p+-i-n+ diode structure positioned between a drain terminal and a source terminal.

In addition, the gated diode 100 has a structure in which a gate insulator is located on the intrinsic region of the p+-i-n+ diode structure, and two gate terminals are located on the gate insulator.

The gated diode 100 according to an embodiment of the present disclosure generates and extinguishes a positive feedback loop on the intrinsic region according to the application of the first gate voltage $V_{G1}$ and the second gate voltage $V_{G2}$.

A supply voltage $V_{DS}$ may be applied through a drain terminal, and a source terminal may be connected to ground GND.

FIG. 1B illustrates the optical image of the gated diode constituting the oscillatory neural network circuitry according to an embodiment of the present disclosure.

Referring to FIG. 1B, an optical image 110 shows that a p+-i-n+ silicon nanosheet NS of the gated diode is surrounded on an oxide in which a polysilicon gate electrode and a silicon gate oxide layer are embedded.

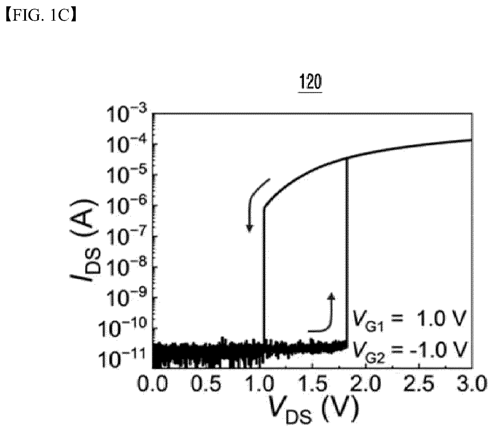

FIG. 1C illustrates the switching characteristics of the gated diode constituting the oscillatory neural network circuitry according to an embodiment of the present disclosure.

Referring to FIG. 1C, Graph 120 shows that, in the gated diode constituting the oscillatory neural network circuitry according to an embodiment of the present disclosure, steep switching characteristics are exhibited in $I_{DS}$ characteristics when the first gate voltage $V_{G1}$ is applied as a positive voltage and the second gate voltage $V_{G2}$ is applied as a negative voltage.

That is, the gated diode according to an embodiment of the present disclosure exhibits latch-up and latch-down characteristics depending on the generation and extinction of the positive feedback loop.

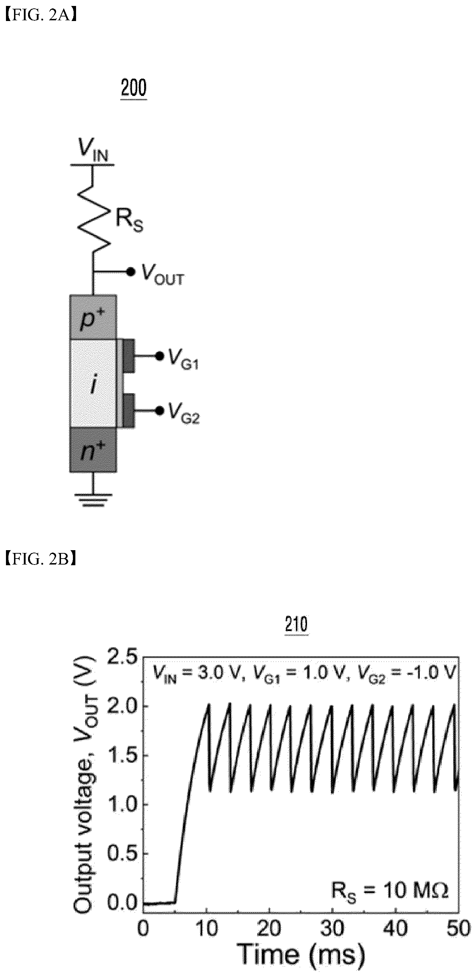

FIGS. 2A to 2C illustrate diagrams explaining the structure and operating characteristics of an oscillator constituting the oscillatory neural network circuitry according to an embodiment of the present disclosure.

FIG. 2A illustrates the structure of the oscillator constituting the oscillatory neural network circuitry according to an embodiment of the present disclosure.

Referring to FIG. 2A, an oscillator 200 constituting the oscillatory neural network circuitry according to an embodiment of the present disclosure are based on a gated diode having a p+-i-n+ diode structure positioned between a drain terminal and a source terminal, a gate insulator located on the intrinsic region of the p+-i-n+ diode structure, and two gate terminals located on the gate insulator, and have a structure in which a resistor is connected in series to the drain terminal of the gated diode.

For example, the gated diode includes a p+ drain region between the first gate terminal among the two gate terminals and the drain terminal, and when a positive voltage is applied to the first gate terminal, a region under the first gate terminal in the intrinsic region may be included as an n* channel region.

In addition, the gated diode includes an n+ source region between the second gate terminal among the two gate terminals and the source terminal, and when a negative voltage is applied to the second gate terminal, a region under the second gate terminal in the intrinsic region may be included as a p* channel region.

The oscillator 200 forms a potential barrier in the intrinsic region by electrostatic doping, as the intrinsic region is changed into either an n* channel region or a p* channel region based on different voltages applied to the two gate terminals of the gated diode.

In addition, the oscillator 200 may output an oscillating output voltage with a constant period, as a positive feedback loop associated with the formed potential barrier is repeatedly generated and extinguished according to electron injection variations based on multiple-carrier injections.

FIG. 2B illustrates oscillation characteristics based on the operation of an oscillator constituting the oscillatory neural network circuitry according to an embodiment of the present disclosure.

Referring to FIG. 2B, Graph 210 illustrates that an output voltage related to oscillation characteristics based on the operation of the oscillator constituting the oscillatory neural network circuitry according to an embodiment of the present disclosure changes over time.

As shown in Graph 210, the output voltage $V_{OUT}$ of the oscillator has a characteristic of oscillating with a constant period.

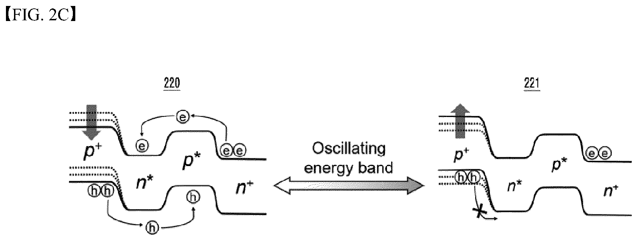

FIG. 2C explains the operating characteristics of the oscillator constituting the oscillatory neural network circuitry according to an embodiment of the present disclosure in terms of changes in energy band structures.

Referring to FIG. 2C, an energy band 220 represents a case in which a positive feedback loop is generated, and an energy band 221 represents a case in which the positive feedback loop is extinguished.

The energy band 220 and the energy band 221 oscillate while repeatedly alternating with each other, and thus oscillation characteristics appear.

In summary, Graph 210 and the energy bands 220 and 221 confirm that the characteristic of the output voltage of the oscillator oscillating with a constant period results from oscillation characteristics appearing as the positive feedback loop is repeatedly generated and extinguished.

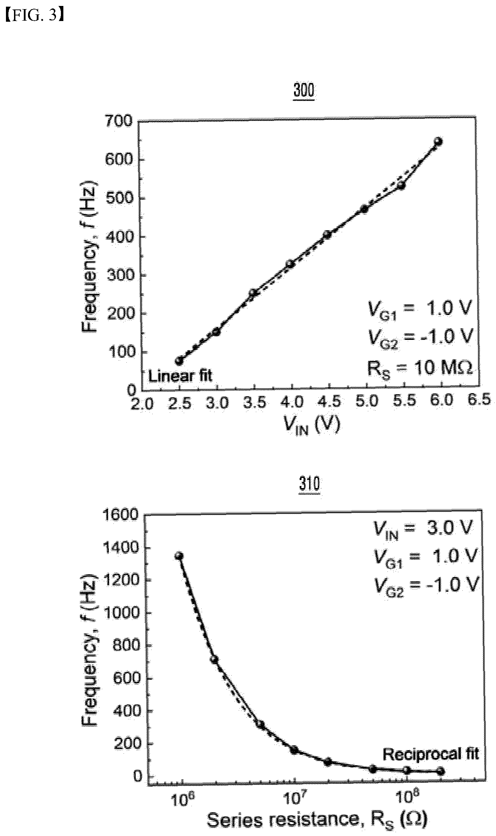

FIG. 3 illustrates a diagram explaining the characteristic variations of the oscillator constituting the oscillatory neural network circuitry according to an embodiment of the present disclosure.

Referring to FIG. 3, Graph 300 shows the frequency variations of the oscillator according to an input voltage $V_{IN}$, and Graph 310 shows the frequency variations of the oscillator according to a resistance $R_S$.

Graphs 300 and 310 show that the frequency changes in a proportional or inversely proportional relationship depending on the input voltage $V_{IN}$ and the resistance $R_S$, and this can be demonstrated through Equation 1 below.

[Equation 1]

$$f_{osc} = \frac{V_{IN}}{R_S} \times \frac{1}{\text{Oscillation amplitude} \times C_{total}}$$

Equation 1 shows that the frequency of the oscillator is proportional to the input voltage $V_{IN}$ and inversely proportional to the resistance $R_S$, and further demonstrates that the oscillation amplitude and the capacitance $C_{total}$ of the oscillator are additionally considered.

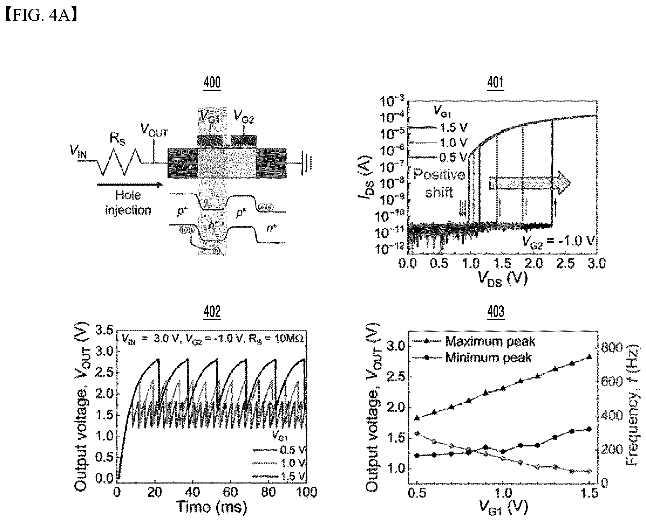

FIGS. 4A to 4B illustrate diagrams explaining the tuning characteristics of the oscillator constituting the oscillatory neural network circuitry according to an embodiment of the present disclosure.

FIG. 4A illustrates variations according to the first gate voltage $V_{G1}$ in relation to tuning characteristics of the oscillator constituting the oscillatory neural network circuitry according to an embodiment of the present disclosure.

Referring to FIG. 4A, the circuit diagram 400 of the oscillator shows that a resistor is connected to a drain terminal, Graph 401 illustrates switching characteristics according to variations of the first gate voltage $V_{G1}$, and Graphs 402 and 403 illustrate that the amplitude and the frequency change through variations in output voltage over time.

The operating characteristics according to the circuit diagram 400 of the oscillator show that the height of the potential barrier of holes injected from the drain region may be controlled according to the first gate voltage $V_{G1}$.

This indicates that, according to Equation 1, the amplitude varies in proportion to latch-up voltage and latch-down voltage, and the frequency is inversely proportional to the amplitude.

According to an embodiment of the present disclosure, the height of the potential barrier of holes injected from the $p^+$ drain region is controlled according to a first gate voltage applied to the first gate terminal when a resistor is connected to the drain terminal.

In addition, as the latch-up voltage at which a positive feedback loop occurs shifts in the positive direction in proportion to the first gate voltage, the amplitude and frequency of the oscillator may change.

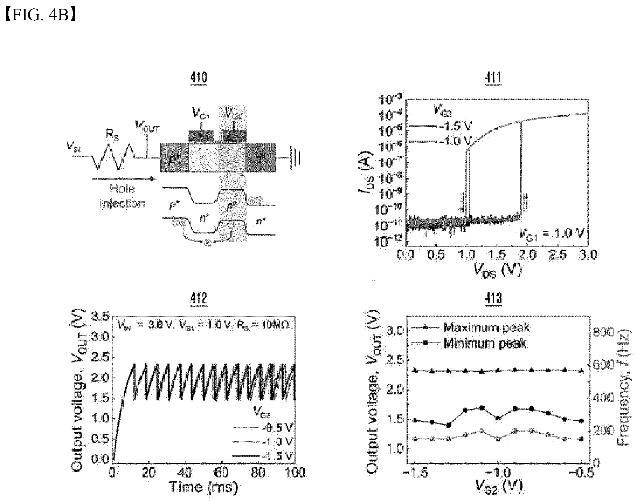

FIG. 4B illustrates variations according to the second gate voltage $V_{G2}$ in relation to tuning characteristics of the oscillator constituting the oscillatory neural network circuitry according to an embodiment of the present disclosure.

Referring to FIG. 4B, the circuit diagram 410 of the oscillator shows that a resistor is connected to a drain terminal, Graph 411 illustrates switching characteristics according to the variations of the second gate voltage $V_{G2}$, and Graphs 412 and 413 illustrate that the amplitude and the frequency do not change through variations in output voltage over time.

That is, the second gate voltage $V_{G2}$ adjusts the depth of a potential well in which injected holes are accumulated, and this shows that it does not affect the switching characteristics of the device and the oscillation characteristics of the oscillator.

The gated diode of the present disclosure may adjust the energy band according to the gate voltage, thereby tuning the characteristics of the oscillator. The tuning characteristics may compensate for the characteristic deviations of fabricated devices, enabling the realization of highly reliable oscillators.

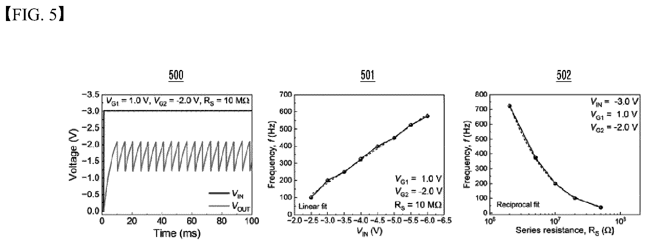

FIG. 5 illustrates a diagram explaining the characteristic variations of the oscillator constituting the oscillatory neural network circuitry according to an embodiment of the present disclosure when the oscillator uses electrons as multiple carriers.

Referring to FIG. 5, Graph 500 shows that when the source region of the gated diode is connected in series with a resistor, oscillation characteristics may be exhibited by using electrons as multiple carriers.

Graph 500 shows that when the input voltage $V_{IN}$ is applied as a negative voltage for electron injection, the output voltage $V_{OUT}$ similarly exhibits oscillating characteristics.

Graphs 501 and 502 show that, consistent with Equation 1, the frequency changes in proportion or inverse proportion depending on the input voltage and the resistance.

In summary, Graphs 500 to 502 show that when a resistor is connected to the source terminal, the oscillation characteristics can be tuned by controlling the second gate voltage $V_{G2}$.

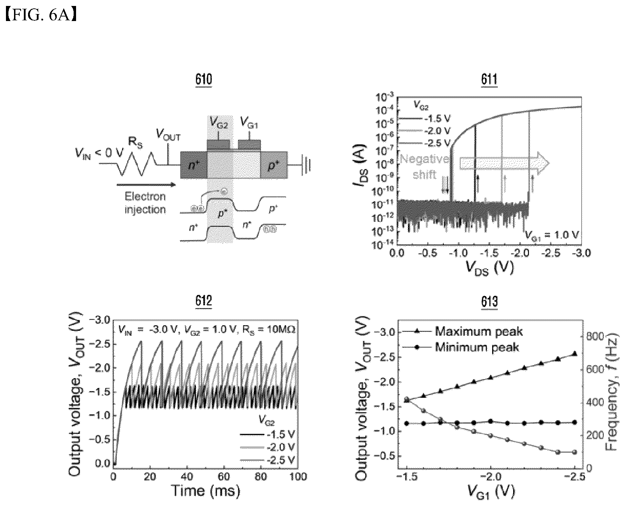

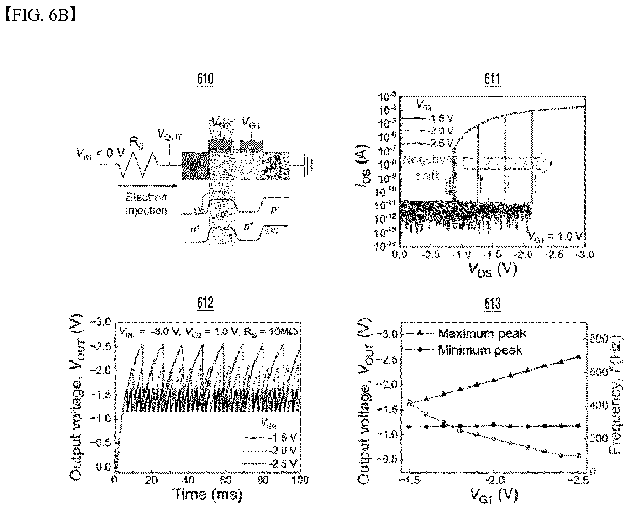

FIGS. 6A and 6B illustrate diagrams explaining the tuning characteristics of the oscillator constituting the oscillatory neural network circuitry according to an embodiment of the present disclosure when the oscillator uses electrons as multiple carriers.

FIG. 6A illustrates variations according to the first gate voltage $V_{G1}$ in relation to tuning characteristics of the oscillator constituting the oscillatory neural network circuitry according to an embodiment of the present disclosure.

Referring to FIG. 6A, the circuit diagram 600 of the oscillator shows that a resistor is connected to the source terminal, graph 601 illustrates switching characteristics according to variations of the first gate voltage $V_{G1}$, and Graphs 602 and 603 illustrate that the amplitude and the frequency do not change through variations in output voltage over time.

That is, in the circuit diagram 600 of the oscillator, it can be confirmed that, since the first gate voltage $V_{G1}$ adjusts the depth of the potential well for injected electrons, the switching characteristics of the gated diode and the oscillation characteristics of the oscillator are not changed.

FIG. 6B illustrates variations according to the second gate voltage $V_{G2}$ in relation to the tuning characteristics of the oscillator constituting the oscillatory neural network circuitry according to an embodiment of the present disclosure.

Referring to FIG. 6B, the circuit diagram 610 of the oscillator shows that a resistor is connected to the source terminal, Graph 611 illustrates switching characteristics according to variations of the second gate voltage $V_{G2}$, and Graphs 612 and 613 illustrate that the amplitude and the frequency change through variations in an output voltage over time.

The operating characteristics according to the circuit diagram 610 of the oscillator show that the height of the potential barrier of holes injected from the drain region may be controlled according to the second gate voltage $V_{G2}$.

This shows that, according to Equation 1, the amplitude varies in proportion to latch-up voltage and latch-down voltage, and the frequency is inversely proportional to the amplitude.

According to an embodiment of the present disclosure, when a resistor is connected to the source terminal, the height of the potential barrier of electrons injected from the n$^+$ source region is controlled according to a second gate voltage applied to the second gate terminal, and as the latch-up voltage shifts in the negative direction in proportion to the second gate voltage, the amplitude and frequency of the oscillator may change.

This shows a tendency opposite to the characteristic variations of the oscillator described in FIG. 4A.

That is, as shown in Graph 611, the amplitude and frequency of the oscillator change as the latch-up voltage shifts in the negative direction.

Accordingly, the oscillator according to an embodiment of the present disclosure may determine a multiple-carrier type depending on the configuration method and may tune their characteristics according to the gate voltage.

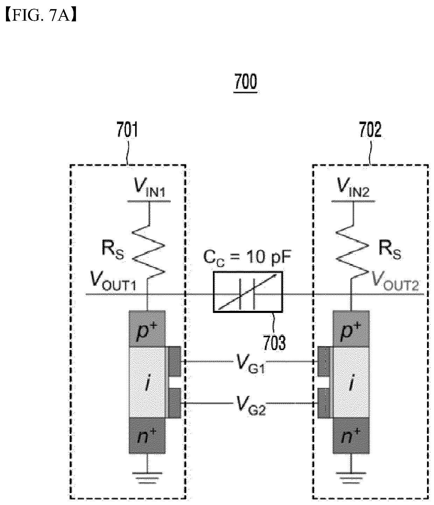

FIGS. 7A to 7C illustrate diagrams explaining the oscillatory neural network circuitry according to an embodiment of the present disclosure and edge detection simulation using the same.

FIG. 7A is a diagram explaining the structure of the oscillatory neural network circuitry according to an embodiment of the present disclosure using oscillators including a gated diode.

Referring to FIG. 7A, an oscillatory neural network circuitry 700 according to an embodiment of the present disclosure using oscillators including a gated diode has a structure in which a first oscillator 701 and a second oscillator 702 are coupled by a coupling capacitor.

For example, the first oscillator 701 and the second oscillator 702 output an oscillating output voltage with a constant period, as the intrinsic region of the gated diode is changed into either the n* channel region or the p* channel region based on different voltages applied to two gate terminals, thereby forming a potential barrier in the intrinsic region by electrostatic doping, and as a positive feedback loop associated with the formed potential barrier is repeatedly generated and extinguished according to electron injection variations based on multiple-carrier injection.

The output terminals of the first and second oscillators 701 and 702 are coupled with each other through a capacitor 703, so that a phase difference in the output voltage may occur depending on a time difference of input voltages applied to the gated diode. For example, the capacitor 703 may be referred to as a coupling capacitor.

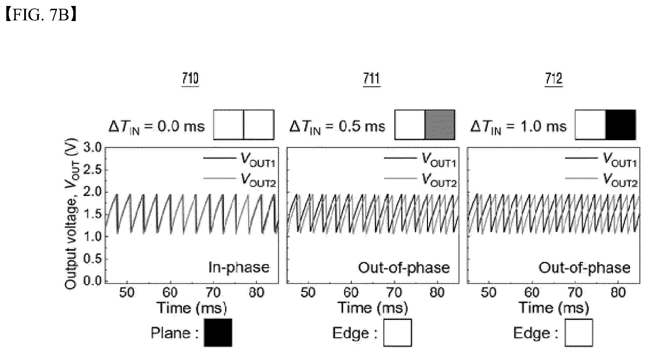

FIG. 7B illustrates oscillation characteristics according to a time difference $\Delta T_{IN}$ of respectively applying an input voltage $V_{IN1}$ and an input voltage $V_{IN2}$ to the first oscillator and the second oscillator constituting the oscillatory neural network circuitry according to an embodiment of the present disclosure.

Referring to FIG. 7B, Graph 710 shows that when $\Delta T_{IN} = 0.0$ ms, the oscillations of the two oscillators exhibit an in-phase relationship even as time elapses.

In contrast, when $\Delta T_{IN} = 0.5$ ms as shown in Graph 711 and $\Delta T_{IN} = 1.0$ ms as shown in Graph 712, the oscillations of the two oscillators interact with each other through the coupling capacitor Cc as time passes, and exhibit an out-of-phase relationship.

For example, the time difference $\Delta T_{IN}$ may represent pixel values of an input image for edge detection.

The oscillatory neural network circuitry according to an embodiment of the present disclosure sets the output pixel value to black when there is no difference between the two input pixel values ($\Delta T_{IN}$ = 0.0 ms) because they are in-phase, and sets the output pixel value to white when there is a difference between the two input pixel values ($\Delta T_{IN}$ = 0.5 or 1.0 ms) because they are out-of-phase.

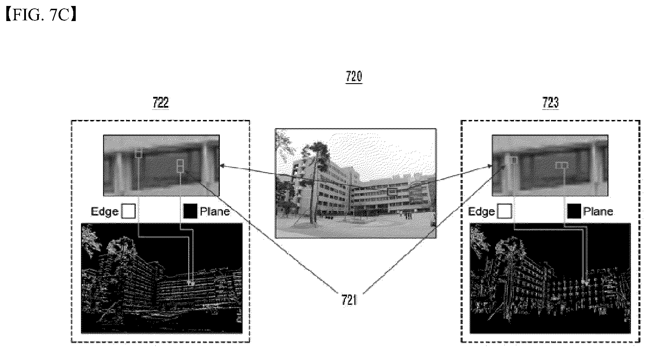

FIG. 7C illustrates edge detection simulation in the oscillatory neural network circuitry according to an embodiment of the present disclosure using oscillators including a gated diode.

Referring to FIG. 7C, according to an embodiment of the present disclosure, simulation 720 illustrates results of performing horizontal edge detection 722 and vertical edge detection 723 through an oscillatory neural network circuitry 721 in which two oscillators are coupled with a time difference $\Delta T_{IN}$ as described in FIG. 7B.

Even when processing the same window image, it can be seen that when the oscillators are coupled vertically, edge components in the horizontal direction 722 are detected, and conversely, when coupled horizontally, edge components in the vertical direction 723 are detected.

That is, when at least two gated diodes are coupled in the horizontal direction through a capacitor, they may output the output voltage corresponding to edge components in the vertical direction, and when coupled in the vertical direction through a capacitor, they may output the output voltage corresponding to edge components in the horizontal direction.

In conclusion, the oscillators of the present disclosure enable selective edge detection depending on the coupling method.

Accordingly, the present disclosure may provide an oscillatory neural network circuitry in which oscillators are realized by utilizing a gated diode and resistor that repeatedly generate and extinguish a positive feedback loop, and which solves combinatorial optimization problems in conjunction with an image processor based on the coupling and synchronization characteristics among the oscillators.

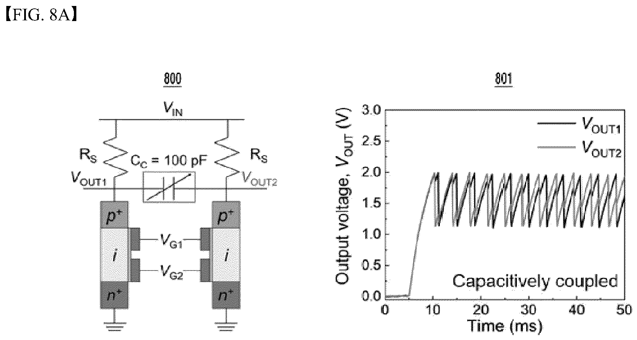

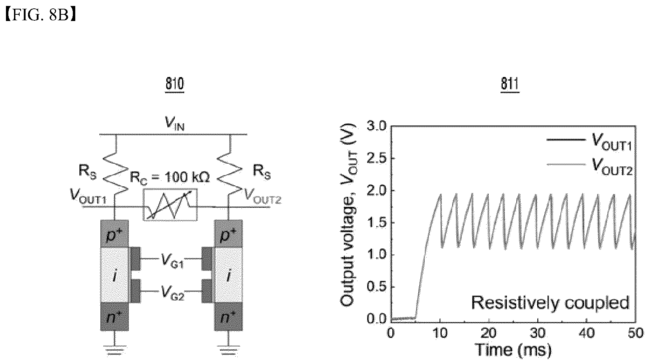

FIGS. 8A and 8B illustrate diagrams explaining the circuit diagram and oscillation characteristics of the oscillatory neural network circuitry according to an embodiment of the present disclosure.

FIG. 8A illustrates the oscillation characteristics of the oscillatory neural network circuitry according to an embodiment of the present disclosure in a structure coupled by a capacitor.

Referring to FIG. 8A, oscillators constituting an oscillatory neural network circuitry 800 according to an embodiment of the present disclosure are coupled by a capacitor.

Graph 801 shows the oscillation characteristics of the oscillatory neural network circuitry 800 according to an embodiment of the present disclosure.

FIG. 8B illustrates the oscillation characteristics of the oscillatory neural network circuitry according to an embodiment of the present disclosure in a structure coupled by a resistor.

Referring to FIG. 8B, oscillators constituting an oscillatory neural network circuitry 810 according to an embodiment of the present disclosure are coupled by a resistor.

Graph 811 shows the oscillation characteristics of the oscillatory neural network circuitry 810 according to an embodiment of the present disclosure.

The oscillatory neural network circuitry according to an embodiment of the present disclosure may solve a graph coloring problem based on combinatorial optimization.

In the oscillatory neural network circuitry 800, the oscillations of two oscillators coupled by a capacitor (CC = 100 pF) are synchronized over time into an out-of-phase state, in which their phase difference becomes 180 degrees.

In Graph 801, when the gated diode of the second oscillator located on the left among the first and second oscillators is turned on, charges accumulated at the output terminal are discharged to ground through the gated diode, and the output voltage $V_{OUT1}$ of the second oscillator sharply decreases.

At the same time, the output voltage $V_{OUT2}$ of the first oscillator also slightly decreases. This is because part of the charge accumulated at the output terminal of the right oscillator flows to ground through the left diode by the capacitor.

The oscillatory neural network circuitry 810 corresponds to a case opposite to that of the oscillatory neural network circuitry 800, and consists of oscillators coupled by a resistor (R_C = 100 kΩ).

As seen in Graph 810, the phases of the oscillators are synchronized into an in-phase state in which their motions are completely identical.

This may be because the coupling resistor $R_C$ is smaller than the series-connected resistance $R_S$ and the resistance value of the gated diode, so that the output terminals of the two oscillators share carriers through voltage division.

Accordingly, the coupling strength of the oscillators of the present disclosure can be expressed by resistors (strong coupling) and capacitors (weak coupling), and the input graph of a graph coloring problem can be mapped to the oscillatory neural network using this.

Therefore, the present disclosure can implement an oscillatory neural network circuitry using oscillators configured with a gated diode, thereby overcoming the processing speed limitations and performance degradation caused by the separation of memory and processor.

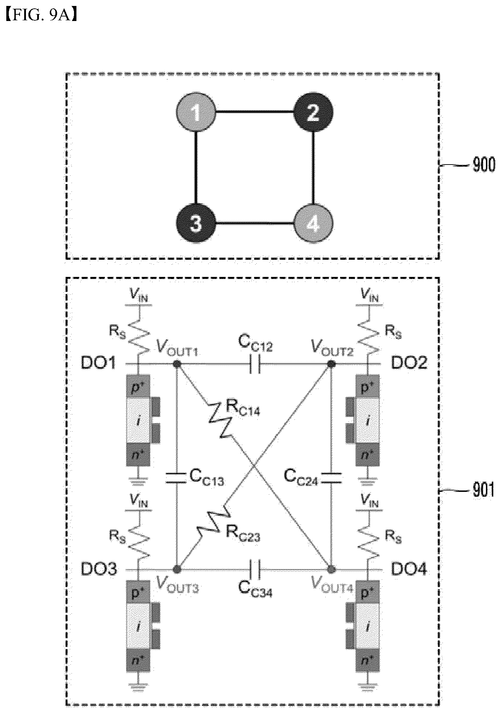

FIGS. 9A to 10 illustrate diagrams explaining configurations for implementing the graph coloring of an input graph by an oscillatory neural network circuitry according to an embodiment of the present disclosure.

FIGS. 9A to 9D illustrate a configuration in which an oscillatory neural network circuitry for an input graph according to an embodiment of the present disclosure is composed of four oscillators to implement graph coloring.

Referring to FIG. 9A, in relation to a configuration where an oscillatory neural network circuitry for an input graph according to an embodiment of the present disclosure is composed of four oscillators to implement graph coloring, one input graph 900 and a corresponding oscillatory neural network circuitry 901 are shown.

Each node 1 to 4 of the input graph 900 corresponds to oscillators DO1 to DO4 of the oscillatory neural network circuitry, and the connections of the nodes employ a coupling capacitor and resistors.

For example, when four oscillators are configured, the output terminals of the first oscillator, second oscillator, third oscillator, and fourth oscillator are coupled horizontally or vertically through a capacitor, and coupled diagonally through a resistor. The outputs coupled through the resistor have the same phase, while a phase difference may occur relative to those coupled through the capacitor.

For example, the horizontal direction may correspond to the lateral direction, and the vertical direction may correspond to the longitudinal direction.

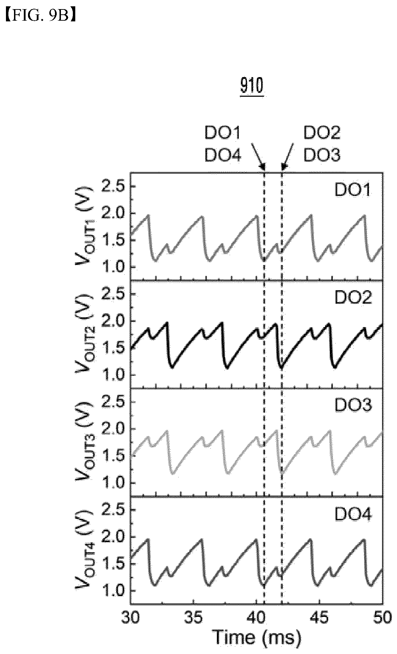

Referring to FIG. 9B, Graph 910 illustrates the operating characteristics of four oscillators constituting the oscillatory neural network circuitry.

The phases of the first oscillator DO1, the second oscillator DO2, the third oscillator DO3, and the fourth oscillator DO4 vary over time, with the first oscillator DO1 and the fourth oscillator DO4 exhibiting the same phase, and the second oscillator DO2 and the third oscillator DO3 exhibiting the same phase.

The first oscillator DO1 and the fourth oscillator DO4 have a strong coupling strength $R_{C14}$, so their phases are identical, while they show a certain phase difference relative to the second oscillator DO2 and the third oscillator DO3.

The second oscillator DO2 and the third oscillator DO3 have a strong coupling strength $R_{C23}$, so their phases are identical, while they show a certain phase difference relative to the first oscillator DO1 and the fourth oscillator DO4.

That is, the first oscillator is coupled horizontally with the second oscillator through a capacitor and vertically with the third oscillator, and outputs an output voltage with a phase different from those of the second oscillator and the third oscillator, while being diagonally coupled with the fourth oscillator through a resistor to output an output voltage with the same phase.

In addition, the second oscillator is coupled horizontally with the first oscillator through a capacitor and vertically with the fourth oscillator, and outputs an output voltage with a phase different from those of the first oscillator and the fourth oscillator, while being diagonally coupled with the third oscillator through a resistor to output an output voltage with the same phase.

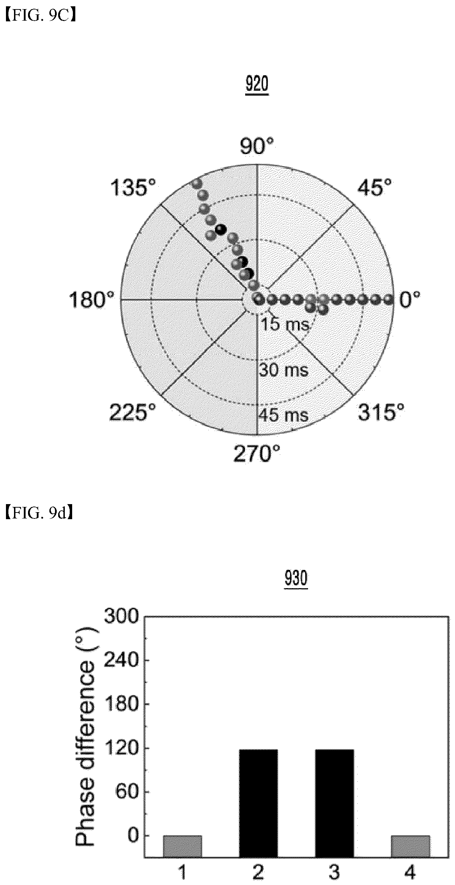

Referring to FIG. 9C, the oscillatory neural network circuitry for an input graph according to an embodiment of the present disclosure illustrates phase variations over time with respect to the output voltage.

Graph 920 shows phase variations over time with respect to the output voltages of the first oscillator and the fourth oscillator.

In Graph 920, the radial axis of the circle represents the passage of time, with the center and circumference indicating 10 ms and 55 ms, respectively.

The phase corresponding to the output voltage of the first oscillator may be taken as the reference (0°).

Depending on the coupling configuration of the oscillatory neural network, the output voltages of the oscillators interact and reach a stable state over time.

The oscillatory neural network circuitry for an input graph according to an embodiment of the present disclosure may be set such that, for a graph coloring problem, different colors (e.g., red and blue) are assigned when the phase difference with respect to the output voltages of the oscillators is ±90° or more.

Referring to FIG. 9D, the oscillatory neural network circuitry for an input graph according to an embodiment of the present disclosure illustrates results of outputting graph colors based on phase differences of the output voltages over time.

Graph 930 shows that, as confirmed in Graph 920 of FIG. 9C, the colors based on the output voltages of the first oscillator and the fourth oscillator are the same, and the colors based on the output voltages of the second oscillator and the third oscillator are the same.

Graph 930 also shows phase differences of the oscillators at 50 ms, demonstrating that the phase of the second oscillator 2 and the fourth oscillator 4 differ by about 120°.

The oscillatory neural network apparatus according to an embodiment of the present disclosure may solve a graph coloring problem by representing graph colors such that nodes 1 and 4 of an input graph are red, and nodes 2 and 3 are blue, based on phase differences.

Accordingly, the present disclosure may provide an oscillatory neural network circuitry wherein a plurality of oscillators coupled by capacitors or resistors detect edges or represent at least two graph colors of an input graph, thereby solving a graph coloring problem.

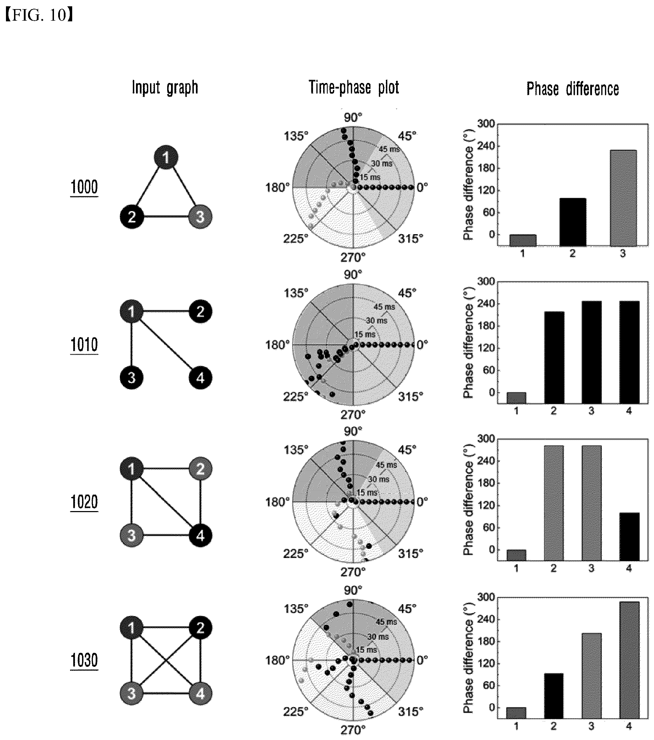

FIG. 10 illustrates various configurations of graph color implementations of an oscillatory neural network circuitry for an input graph according to an embodiment of the present disclosure.

Referring to FIG. 10, in various input graphs such as a first embodiment 1000, a second embodiment 1010, a third embodiment 1020, and a fourth embodiment 1030, phase variations over time can be confirmed, and graph colors are represented according to the phase differences, thereby solving the graph coloring problem.

For an input graph, the oscillators interact over time, and their phases become stabilized.

Unlike conventional oscillatory neural networks that require applying an appropriate coloring algorithm depending on the input graph, the oscillatory neural network of the present disclosure can solve all coloring problems based on a phase difference of $\pm 45°$, regardless of the input graph, as shown in the phase difference graph.

In other words, at least two graph colors consisting of a first color corresponding to an output voltage of the same phase and a second color corresponding to an output voltage having a phase difference may be represented.

According to an embodiment of the present disclosure, the oscillatory neural network circuitry may consider the number of nodes, node connections, and node colors constituting an input graph, and by using oscillators corresponding to the number of nodes, determine a color separation criterion for phase differences through phase variations of the oscillators over time based on the phase differences, and represent at least two graph colors with separated colors according to the color separation criterion.

Therefore, the present disclosure can implement an oscillatory neural network circuitry using highly reliable and highly integrated oscillators applicable to existing CMOS processes, which can be utilized as image processor and combinatorial optimization problem (COP) solvers.

The present disclosure can provide an oscillatory neural network circuitry in which oscillators are realized by utilizing a gated diode and resistor that repeatedly generate and extinguish a positive feedback loop, and which solves combinatorial optimization problems in conjunction with an image processor based on coupling and synchronization characteristics among oscillators.

The present disclosure can provide an oscillatory neural network circuitry that overcomes processing speed limitations and performance degradation caused by the separation of memory and processor, by implementing oscillators configured with a gated diode.

The present disclosure can provide an oscillatory neural network circuitry in which a plurality of oscillators coupled by capacitors or resistors may detect edges or solve a graph coloring problem by representing at least two graph colors of an input graph.

The present disclosure can provide an oscillatory neural network circuitry that may be implemented as image processors and combinatorial optimization problem (COP) solvers, by employing highly reliable and highly integrated oscillators applicable to existing CMOS processes.

In the aforementioned embodiments, constituents of the present disclosure were expressed in a singular or plural form depending upon embodiments thereof.

However, the singular or plural expressions should be understood to be suitably selected depending upon a suggested situation for convenience of description, and the aforementioned embodiments should be understood not to be limited to the disclosed singular or plural forms. In other words, it should be understood that plural constituents may be a singular constituent or a singular constituent may be plural constituents.

While the embodiments of the present disclosure have been described, those skilled in the art will appreciate that many modifications and changes can be made to the present disclosure without departing from the spirit and essential characteristics of the present disclosure.

Therefore, it should be understood that there is no intent to limit the disclosure to the embodiments disclosed, rather, the disclosure is to cover all modifications, equivalents, and alternatives falling within the spirit and scope of the disclosure as defined by the claims.

**Claims**

1. An oscillatory neural network circuitry using oscillators comprising a gated diode, wherein a $p^+$-i-$n^+$ diode structure is positioned between a drain terminal and a source terminal, a gate insulator is located on an intrinsic region of the $p^+$-i-$n^+$ diode structure, and two gate terminals are located on the gate insulator, thereby forming a gated diode, and wherein the oscillators comprise a resistor connected in series to the gated diode,

   the oscillators output an oscillating output voltage with a constant period as the intrinsic region is changed into either an n* channel region or a p* channel region based on different voltages applied to the two gate terminals of the gated diode, thereby forming a potential barrier in the intrinsic region through electrostatic doping, and as a positive feedback loop associated with the formed potential barrier is repeatedly generated and extinguished according to multiple-carrier injection variations,
   when at least two oscillators are configured, output terminals corresponding to portions where resistors are connected to the respective gated diodes are coupled with each other through either a capacitor or a resistor, so that a phase difference in output voltage occurs depending on a time difference of input voltages applied to the at least two gated diodes, thereby representing at least two graph colors of an input graph based on the time-dependent phase difference.

2. The oscillatory neural network circuitry according to claim 1, wherein when the gated diode comprises a $p^+$ drain region between the first gate terminal among the two gate terminals and the drain terminal, and a positive voltage is applied to the first gate terminal, a region under the first gate terminal in the intrinsic region is comprised as an $n^*$ channel region, and when the gated diode comprises an $n^+$ source region between the second gate terminal among the two gate terminals and the source terminal, and a negative voltage is applied to the second gate terminal, a region under the second gate terminal in the intrinsic region is comprised as a $p^*$ channel region.

3. The oscillatory neural network circuitry according to claim 2, wherein when the resistor is connected to the drain terminal, a height of a potential barrier of holes injected from the $p^+$ drain region is controlled according to a first gate voltage applied to the first gate terminal, and as a latch-up voltage at which a positive feedback loop occurs shifts in a positive direction in proportion to the first gate voltage, amplitudes and frequencies of the oscillators are changed.

4. The oscillatory neural network circuitry according to claim 2, wherein when the resistor is connected to the source terminal, a height of a potential barrier of electrons injected from the $n^+$ source region is controlled according to a second gate voltage applied to the second gate terminal, and as a latch-up voltage shifts in a negative direction in proportion to the second gate voltage, amplitudes and frequencies of the oscillators are changed.

5. The oscillatory neural network circuitry according to claim 1, wherein, based on a time difference between a first input voltage and a second input voltage applied to each of the at least two gated diodes, an effect occurs between the at least two gated diodes through the capacitor as time elapses, and a first output pixel value is determined based on an output voltage that is output in an out-of-phase state representing opposite movement, or, when no time difference occurs such that the first input voltage and the second input voltage are applied at same time, a second output pixel value opposite to the first output pixel value is determined based on the output voltage that is output in an in-phase state.

6. The oscillatory neural network circuitry according to claim 1, wherein when each of the at least two gated diodes is coupled horizontally through the capacitor, the output voltage representing vertical edge components is output, and when coupled vertically through the capacitor, the output voltage representing horizontal edge components is output.

7. The oscillatory neural network circuitry according to claim 1, wherein when four oscillators are configured, output terminals of a first oscillator, a second oscillator, a third oscillator, and a fourth oscillator constituting the four oscillators are coupled horizontally or vertically through the capacitor, and are coupled diagonally through a resistor, such that the outputs coupled through the resistor have same phase, and a phase difference occurs relative to the phase coupled through the capacitor.

8. The oscillatory neural network circuitry according to claim 7, wherein the first oscillator is coupled horizontally with the second oscillator through the capacitor and vertically with the third oscillator, and outputs an output voltage having a phase difference from those of the second oscillator and the third oscillator, and is diagonally coupled with the fourth oscillator through the resistor to output an output voltage of same phase, and
the second oscillator is coupled horizontally with the first oscillator through the capacitor and vertically with the fourth oscillator, and outputs an output voltage having a phase difference from those of the first oscillator and the third oscillator, and is diagonally coupled with the third oscillator through the resistor to output an output voltage of same phase.

9. The oscillatory neural network circuitry according to claim 8, wherein at least two graph colors consisting of a first color corresponding to an output voltage of the same phase and a second color corresponding to an output voltage with the phase difference are represented.

10. The oscillatory neural network circuitry according to claim 8, wherein by considering the number of nodes, node connections, and node colors constituting the input graph, and by using oscillators corresponding to the number of nodes, a color separation criterion for the phase difference is determined through phase variations of the oscillators over time, and the at least two graph colors are represented with colors separated according to the color separation criterion.

【FIG. 1A】

<u>100</u>

【FIG. 1B】

<u>110</u>

【FIG. 1C】

【FIG. 2A】

200

【FIG. 2B】

210

【FIG. 2C】

220      Oscillating energy band      221

【FIG. 3】

300

310

【FIG. 4A】

【FIG. 4B】

【FIG. 5】

【FIG. 6A】

【FIG. 6B】

【FIG. 7A】

700

701                                    702

$V_{IN1}$                              $V_{IN2}$

$R_S$        $C_C = 10\ pF$        $R_S$

$V_{OUT1}$                          $V_{OUT2}$

703

$p^+$                                  $p^+$

$i$          $V_{G1}$          $i$

$V_{G2}$

$n^+$                                  $n^+$

【FIG. 7B】

Figure showing three graphs (710, 711, 712) of Output voltage, $V_{OUT}$ (V) versus Time (ms) for $\Delta T_{IN} = 0.0$ ms (In-phase, Plane), $\Delta T_{IN} = 0.5$ ms (Out-of-phase, Edge), and $\Delta T_{IN} = 1.0$ ms (Out-of-phase, Edge).

【FIG. 7C】

【FIG. 8A】

【FIG. 8B】

810

$V_{IN}$

$R_S$   $R_C = 100\ k\Omega$   $R_S$

$V_{OUT1}$   $V_{OUT2}$

$p^+$   $V_{G1}$   $p^+$

$i$   $V_{G2}$   $i$

$n^+$   $n^+$

811

Resistively coupled

【FIG. 9A】

【FIG. 9B】

【FIG. 9C】

920

【FIG. 9d】

930

【FIG. 10】

# EUROPEAN SEARCH REPORT

**Application Number**

EP 25 19 4897

## DOCUMENTS CONSIDERED TO BE RELEVANT

| Category | Citation of document with indication, where appropriate, of relevant passages | Relevant to claim |
|---|---|---|
| A | US 2017/330623 A1 (KIM SANGSIG [KR] ET AL) 16 November 2017 (2017-11-16) * paragraph [0064] * * paragraph [0066] * * paragraph [0070] * * paragraph [0084] * * figure 1 * ----- | 1-10 |
| A | JP 2024 529613 A (MICRONICS INT CO LTD) 8 August 2024 (2024-08-08) * paragraph [0058] - paragraph [0090] * * figures 1a, 1b * ----- | 1-10 |

**CLASSIFICATION OF THE APPLICATION (IPC)**

INV.
G06N3/065

**TECHNICAL FIELDS SEARCHED (IPC)**

G06N

The present search report has been drawn up for all claims

| Place of search | Date of completion of the search | Examiner |
|---|---|---|
| The Hague | 7 October 2025 | Baldan, Marco |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 19 4897

This annex lists the patent family members relating to the patent documents cited in the above-mentioned European search report.
The members are as contained in the European Patent Office EDP file on
The European Patent Office is in no way liable for these particulars which are merely given for the purpose of information.

07-10-2025

| Patent document cited in search report | Publication date | Patent family member(s) | Publication date |
|---|---|---|---|
| US 2017330623 A1 | 16-11-2017 | KR 20170127645 A<br>US 2017330623 A1 | 22-11-2017<br>16-11-2017 |
| JP 2024529613 A | 08-08-2024 | DE 112022002961 T5<br>JP 7659853 B2<br>JP 2024529613 A<br>KR 102475066 B1<br>US 2025275117 A1<br>WO 2023063732 A1 | 11-04-2024<br>10-04-2025<br>08-08-2024<br>07-12-2022<br>28-08-2025<br>20-04-2023 |

EPO FORM P0459

For more details about this annex : see Official Journal of the European Patent Office, No. 12/82

**EP 4 693 108 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240106829